# EUROPEAN PATENT APPLICATION

(11) **EP 2 117 120 A1**
(43) Date of publication of application: **11.11.2009**
(21) Application number: 08703547.3
(22) Date of filing: 21.01.2008
(51) Int. Cl.: H03H 9/64, H01L 41/09, H01L 41/18, H03H 9/145, H03H 9/25, H03H 9/72

(54) **ELASTIC WAVE FILTER DEVICE AND DUPLEXER**

(30) Priority: 01.03.2007 JP 2007051686
(71) Applicant: Murata Manufacturing Co. Ltd., Kyoto 617-8555 (JP)
(72) Inventor: TAKAMINE, Yuichi, Nagaokakyo-shi Kyoto 617-8555 (JP)
(74) Representative: Thévenet, Jean-Bruno
(86) International application number: PCT/JP2008/050697
(87) International publication number: WO 2008/108113

(57) **Abstract**

A second band pass filter that is used in a filter device that is not only capable of increasing impedance in the second band pass filter, which has a relatively high pass band, in the pass band of a first band pass filter so as to achieve sufficiently large attenuation but also capable of improving insertion loss in the pass band of the first band pass filter is provided. One end of a second IDT (10b) of a second longitudinally coupled resonator surface acoustic wave filter part (10) is connected to a first balanced terminal (7) whereas the other end thereof is connected to a second balanced terminal (8). Each of a first longitudinally coupled resonator surface acoustic wave filter part (9) and the second longitudinally coupled resonator surface acoustic wave filter part (10) has narrow pitch electrode finger parts. The number of electrode fingers of the narrow pitch electrode finger part of the second IDT (9b) of the first longitudinally coupled resonator surface acoustic wave filter part (9) is larger than the number of electrode fingers of the narrow pitch electrode finger part of the second IDT (10b) of the second longitudinally coupled resonator surface acoustic wave filter part (10).

## Description

### Technical Field

The present invention generally relates to an acoustic wave filter apparatus that is used, for example, in an RF duplexer of a mobile phone. In particular, the invention relates to an acoustic wave filter apparatus that has a balanced/unbalanced conversion function and is used as one of two filters that has a pass band relatively high frequency side in the duplexer. In addition, the invention relates to a duplexer that includes such an acoustic wave filter apparatus.

### Background Art

In the field of a mobile phone, there is a demand for a part that has a plurality of functions for the purpose of reducing the number of parts. As an example of a part that offers a plurality of functions for attaining such an objective, various kinds of a duplexer that is provided with a transmission-side band pass filter and a reception-side band pass filter have been proposed in the art.

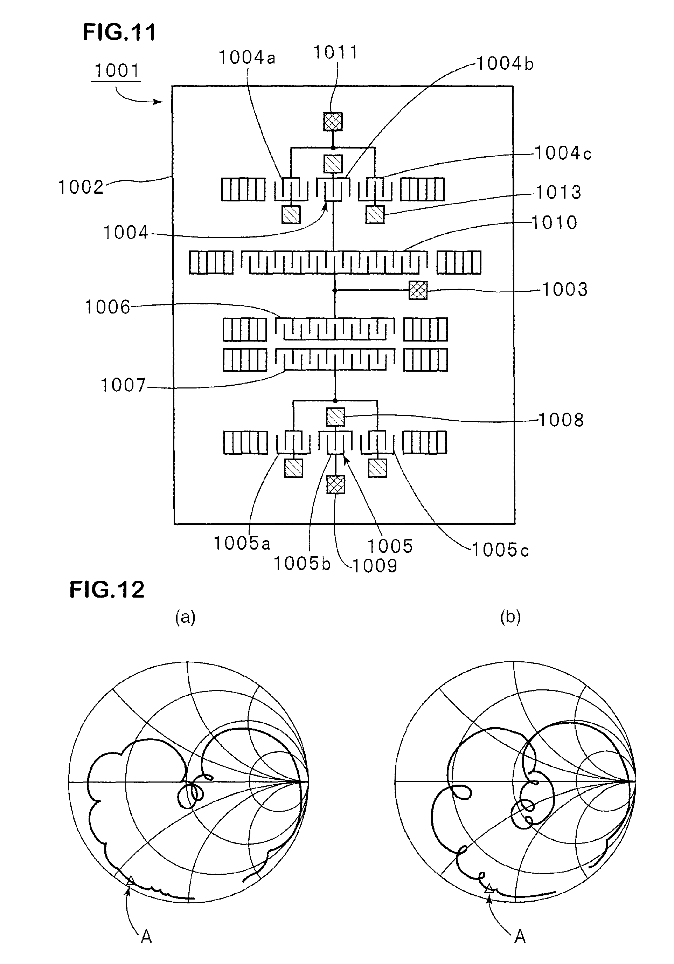

For example, a duplexer that is schematically illustrated in a plan view of Fig. 11 is disclosed in patent document 1 identified below. A duplexer 1001 is provided with a piezoelectric substrate 1002. An electrode structure that is schematically illustrated in Fig. 11 is formed on the piezoelectric substrate 1002 so as to make up a transmission-side band pass filter 1004 and a reception-side band pass filter 1005. The pass band of the reception-side band pass filter 1005 is higher in frequency than the pass band of the transmission-side band pass filter 1004.

The reception-side band pass filter 1005 is connected to a common terminal 1003, which is connected to an antenna, through surface acoustic wave resonators 1006 and 1007. The reception-side band pass filter 1005 is a 3IDT-type longitudinally coupled resonator surface acoustic wave filter. The reception-side band pass filter 1005 includes a first IDT 1005a, a second IDT 1005b, and a third IDT 1005c arrayed in sequence along a surface acoustic wave propagation direction. One end of the second IDT 1005b is connected to a first balanced terminal 1008. The other end of the second IDT 1005b is connected to a second balanced terminal 1009. That is, the reception-side band pass filter 1005 is a float-balance type longitudinally coupled resonator surface acoustic wave filter having a balanced/unbalanced conversion function.

On the other hand, the transmission-side band pass filter 1004 includes a first IDT 1004a, a second IDT 1004b, and a third IDT 1004c. The second IDT 1004b, which is provided at the center thereof, is connected to the common terminal 1003 through a surface acoustic wave resonator 1010. One end of the first IDT 1004a and one end of the third IDT 1004c are connected in common to a transmission terminal 1011. Each of a plurality of terminals excluding the common terminal 1003, the first balanced terminal 1008, the second balanced terminal 1009, and the transmission terminal 1011 mentioned above is connected to ground potential. For example, a terminal 1013 is connected to ground potential.

In the duplexer 1001, it is preferable that impedance should be high in the transmission-side band pass filter 1004 in the pass band of the reception-side band pass filter 1005. Ideally, the impedance should be infinite. In like manner, it is preferable that impedance should be high in the reception-side band pass filter 1005 in the pass band of the transmission-side band pass filter 1004. Ideally, the impedance should be infinite.

For this reason, the one-port surface acoustic wave resonators 1006 and 1007 are provided between the reception-side band pass filter 1005 and the common terminal 1003. With the one-port surface acoustic wave resonators 1006 and 1007 being connected between the reception-side band pass filter 1005 and the common terminal 1003, it is possible to increase the impedance of the reception-side band pass filter 1005 in the pass band of the transmission-side band pass filter 1004.

In the description of this specification, the increasing of the impedance of one band pass filter such as the transmission-side band pass filter or the reception-side band pass filter explained above in the pass band of the other band pass filter is referred to as "phase adjustment" whenever appropriate.
[Patent Document] Japanese Unexamined Patent Application Publication No. H10-341135 Disclosure of the Invention

In a configuration in which the surface acoustic wave resonators 1006 and 1007 are connected between the reception-side band pass filter 1005, that is, a longitudinally coupled resonator surface acoustic wave filter, and the common terminal 1003, which is connected to the antenna, as described in the patent document 1, a problem arises in that the insertion loss of the reception-side band pass filter 1005 increases due to the insertion of the surface acoustic wave resonators 1006 and 1007.

As an alternative method for making phase adjustment defined above, specifically, as another method for increasing the impedance of the reception-side band pass filter 1005 in the pass band of the transmission-side band pass filter 1004, there is a method of reducing the number of electrode finger pairs of the first IDT 1005a and the third IDT 1005c. That is, a method of reducing the number of electrode finger pairs of the IDT 1005a and the IDT 1005c, each of which is an IDT that is connected to the terminal of the antenna, is known as such an alternative method.

Fig. 12 is a set of impedance Smith charts that illustrates the result of phase adjustment when the number of electrode finger pairs of the IDTs 1005a and 1005c explained above is reduced. Fig. 12(a) is an impedance Smith chart that shows pre-phase-adjustment characteristics. Fig. 12(b) is an impedance Smith chart that shows the result of phase adjustment when the number of electrode finger pairs of each of the first IDT 1005a and the third IDT 1005c is made smaller with the subtraction of five pairs therefrom.

Note that the characteristics illustrated in Figs. 12(a) and 12(b) is an example of characteristics obtained when an EGSM reception filter is formed as the reception-side band pass filter 1005.

A marker A is shown in Figs. 12(a) and 12(b). The marker A indicates the position of the center frequency of the EGSM transmission frequency band, which is 897.5 MHz. In comparison with the characteristics shown in Fig. 12(a), it is understood that the impedance at the frequency of 897.5 MHz in the characteristics shown in Fig. 12(b) is shifted to a higher impedance side.

However, if the method of reducing the number of electrode finger pairs of the first IDT 1005a and the third IDT 1005c is adopted, a resistance value in the pass band of the transmission-side band pass filter 1004 in the reception-side band pass filter 1005 increases. For this reason, a problem arises in that the insertion loss of the transmission-side band pass filter 1004 worsens when the duplexer 1001 is configured.

In view of the state of prior art explained above, as an object thereof, the present invention aims to provide an acoustic wave filter apparatus that has a balanced/unbalanced conversion function and is used as a second band pass filter of a duplexer that includes a first band pass filter that has a pass band at a relatively low frequency side and the second band pass filter that has a pass band at a relatively high frequency side. When the duplexer is configured, the acoustic wave filter apparatus to which the invention is directed is capable of increasing impedance of the second band pass filter in the pass band of the first band pass filter without causing an increase in the insertion loss of the first band pass filter. The invention further aims to provide the duplexer that is provided with such an acoustic wave filter apparatus as the second band pass filter thereof.

The invention provides, as an aspect thereof, an acoustic wave filter apparatus that has a balanced/unbalanced conversion function and is used as a second band pass filter of an acoustic wave filter device that includes a first band pass filter that has a pass band at a relatively low frequency side and the second band pass filter that has a pass band at a relatively high frequency side, one end of the first band pass filter and one end of the second band pass filter being connected to a common terminal, the acoustic wave filter apparatus including: a piezoelectric substrate; and a first longitudinally coupled resonator acoustic wave filter part and a second longitudinally coupled resonator acoustic wave filter part that are formed over the piezoelectric substrate, wherein each of the first longitudinally coupled resonator acoustic wave filter part and the second longitudinally coupled resonator acoustic wave filter part includes a first IDT, a second IDT, and a third IDT arrayed in sequence along a propagation direction of an acoustic wave, one end of the first IDT of the first longitudinally coupled resonator acoustic wave filter part and one end of the first IDT of the second longitudinally coupled resonator acoustic wave filter part are connected to each other, and in addition thereto, one end of the third IDT of the first longitudinally coupled resonator acoustic wave filter part and one end of the third IDT of the second longitudinally coupled resonator acoustic wave filter part are connected to each other so that the first longitudinally coupled resonator acoustic wave filter part and the second longitudinally coupled resonator acoustic wave filter part are connected in cascade, an end of the second IDT of the first longitudinally coupled resonator acoustic wave filter part is connected to the common terminal, one end of the second IDT of the second longitudinally coupled resonator acoustic wave filter part is connected to a first balanced terminal whereas the other end of the second IDT of the second longitudinally coupled resonator acoustic wave filter part is connected to a second balanced terminal, each of the first longitudinally coupled resonator acoustic wave filter part and the second longitudinally coupled resonator acoustic wave filter part has a narrow pitch electrode finger part that is provided at a gap-facing part in a pair of the IDTs that are provided adjacent to each other with a gap being formed therebetween when viewed in the acoustic wave propagation direction, a cycle of electrode fingers of the narrow pitch electrode finger part is smaller than a cycle of electrode fingers of an IDT part excluding the narrow pitch electrode finger part, and the number of the electrode fingers of the narrow pitch electrode finger part of the second IDT of the first longitudinally coupled resonator acoustic wave filter part is larger than the number of the electrode fingers of the narrow pitch electrode finger part of the second IDT of the second longitudinally coupled resonator acoustic wave filter part.

It is preferable that an acoustic wave filter apparatus should include a plurality of acoustic wave filter apparatuses according to an aspect of the invention, wherein the plurality of acoustic wave filter apparatuses are connected in parallel. With such a preferred configuration, since the plurality of acoustic wave filter apparatuses are connected in parallel, it is possible to further reduce the insertion loss of the second band pass filter.

In an acoustic wave filter apparatus according to an aspect of the invention, a surface acoustic wave may be used as an acoustic wave. By this means, it is possible to provide a surface acoustic wave filter apparatus according to an aspect of the invention that is capable of increasing impedance of the second band pass filter in the pass band of the first band pass filter without causing an increase in the insertion loss of the first band pass filter.

In an acoustic wave filter apparatus according to an aspect of the invention, a boundary acoustic wave may be used as an acoustic wave. By this means, it is possible to provide a boundary acoustic wave filter apparatus according to an aspect of the invention that is capable of increasing impedance of the second band pass filter in the pass band of the first band pass filter without causing an increase in the insertion loss of the first band pass filter.

A duplexer according to an aspect of the invention includes a first band pass filter that has a relatively low frequency pass band and a second band pass filter that has a relatively high frequency pass band. One end of the first band pass filter of the duplexer and one end of the second band pass filter thereof are connected to a common terminal. In addition, the second band pass filter of the duplexer is an acoustic wave filter apparatus according to an aspect of the invention. Therefore, it is possible to provide a duplexer that is capable of increasing impedance in the second band pass filter in the pass band of the first band pass filter without causing an increase in the insertion loss of the first band pass filter and the second band pass filter and thus offers excellent filter characteristics.

### (Advantages)

An acoustic wave filter apparatus according to an aspect of the invention is a so-called float-balance type acoustic wave filter part including a first longitudinally coupled resonator acoustic wave filter part and a second longitudinally coupled resonator acoustic wave filter part connected in cascade in which an end of a second IDT of the first longitudinally coupled resonator acoustic wave filter part is connected to a common terminal, which serves as an unbalanced terminal, one end of the second IDT of the second longitudinally coupled resonator acoustic wave filter part is connected to a first balanced terminal whereas the other end of the second IDT of the second longitudinally coupled resonator acoustic wave filter part is connected to a second balanced terminal. In such a configuration of the acoustic wave filter apparatus according to an aspect of the invention, the number of electrode fingers of a narrow pitch electrode finger part of the second IDT of the first longitudinally coupled resonator acoustic wave filter part is larger than the number of electrode fingers of a narrow pitch electrode finger part of the second IDT of the second longitudinally coupled resonator acoustic wave filter part. Accordingly, the number of electrode fingers of the IDT connected to the common terminal in the configuration of the acoustic wave filter apparatus according to an aspect of the invention is larger than that of a neutral-point type longitudinally coupled resonator acoustic wave filter having a balanced/unbalanced conversion function. Therefore, it is possible to make resistance in the pass band of the first band pass filter in the second band pass filter larger, which makes it further possible to, in the second band pass filter, increase impedance in the pass band of the first band pass filter without causing an increase in insertion loss.

Thus, the invention makes it possible to increase impedance in the second band pass filter in the pass band of the first band pass filter without causing an increase in insertion loss. That is, the invention makes it possible to make the phase adjustment defined above. In addition, it is possible to achieve design simplification because the surface acoustic wave resonators 1006 and 1007 and the like, which are illustrated in Fig. 11, can be omitted.

### Brief Description of the Drawings

[Fig. 1] Fig. 1 is a plan view that schematically illustrates a duplexer according to an embodiment of the present invention;
[Fig. 2] Fig. 2 is a plan view that schematically illustrates narrow pitch electrode finger parts that are formed in IDTs in the embodiment of the present invention illustrated in Fig. 1;
[Fig. 3] Fig. 3 is a diagram that shows the transmission characteristics of a reception-side band pass filter in a duplexer according to an embodiment of the present invention and the transmission characteristics of a reception-side band pass filter in a duplexer according to a comparative example;
[Fig. 4] Fig. 4 is a diagram that shows the transmission characteristics of a transmission-side band pass filter in a duplexer according to an embodiment of the present invention and the transmission characteristics of a transmission-side band pass filter in a duplexer according to a comparative example;
[Fig. 5] Fig. 5 is a diagram that shows the transmission characteristics of each of a transmission-side band pass filter according to an embodiment of the present invention and a transmission-side band pass filter according to a comparative example that are obtained when loss due to impedance mismatching in the transmission-side band pass filter is eliminated through calculation;
[Fig. 6] Fig. 6 is a plan view that schematically illustrates a surface acoustic wave filter apparatus prepared as a comparative example;
[Fig. 7] Figs. 7(a) and 7(b) are impedance Smith charts for a reception-side band pass filter in a duplexer according to an embodiment of the present invention and for a reception-side band pass filter in a duplexer in a duplexer according to a comparative example, respectively;
[Fig. 8] Fig. 8 is a plan view that schematically illustrates a duplexer according to a modification example of the embodiment of the present invention illustrated in Fig. 1;
[Fig. 9] Fig. 9 is a plan view that schematically illustrates a duplexer according to another modification example of the embodiment of the present invention illustrated in Fig. 1;
[Fig. 10] Fig. 10 is a front-elevation sectional view that schematically illustrates an example of a boundary acoustic wave filter apparatus;
[Fig. 11] Fig. 11 is a plan view that schematically illustrates an example of a duplexer of prior art; and
[Fig. 12] Fig. 12(a) is a diagram that shows an impedance Smith chart for a reception-side band pass filter in a duplexer of prior art whereas Fig. 12(b) is a diagram that shows an impedance Smith chart obtained when the number of electrode finger pairs of each of IDTs connected to a common terminal is made smaller than that of Fig. 12(a) with the subtraction of five pairs therefrom.

### Reference Numerals

- 1: Duplexer
- 2: Piezoelectric Substrate
- 3: Common Terminal
- 4: Transmission-side Band Pass Filter
- 5: Reception-side Band Pass Filter
- 6: Transmission Terminal
- 7, 8: First Balanced Terminal, Second Balanced Terminal
- 9: First Longitudinally Coupled Resonator Surface Acoustic Wave Filter Part
- 9a, 9b, 9c: First IDT, Second IDT, Third IDT
- 9a₁, 9b₁, 9b₂, 9c₁: Narrow Pitch Electrode Finger Part
- 9d, 9e: Reflector
- 10: Second Longitudinally Coupled Resonator Surface Acoustic Wave Filter Part
- 10a, 10b, 10c: First IDT, Second IDT, Third IDT
- 10d, 10e: Reflector
- 11: First Longitudinally Coupled Resonator Surface Acoustic Wave Filter Part
- 11a, 11b, 11c: First IDT, Second IDT, Third IDT
- 11d, 11e: Reflector
- 12: Second Longitudinally Coupled Resonator Surface Acoustic Wave Filter Part
- 12a, 12b, 12c: First IDT, Second IDT, Third IDT
- 12d, 12e: Reflector
- S1, S2, S3: Serial Arm Resonator
- P1, P2: Parallel Arm Resonator
- 101: Duplexer
- 201: Boundary Acoustic Wave Filter Apparatus
- 202: Piezoelectric Substrate
- 203: Dielectric
- 204: Electrode Structure

### Best Mode for Carrying Out the Invention

With reference to the accompanying drawings, an example embodiment of the present invention will now be explained so as to clarify features of the invention.

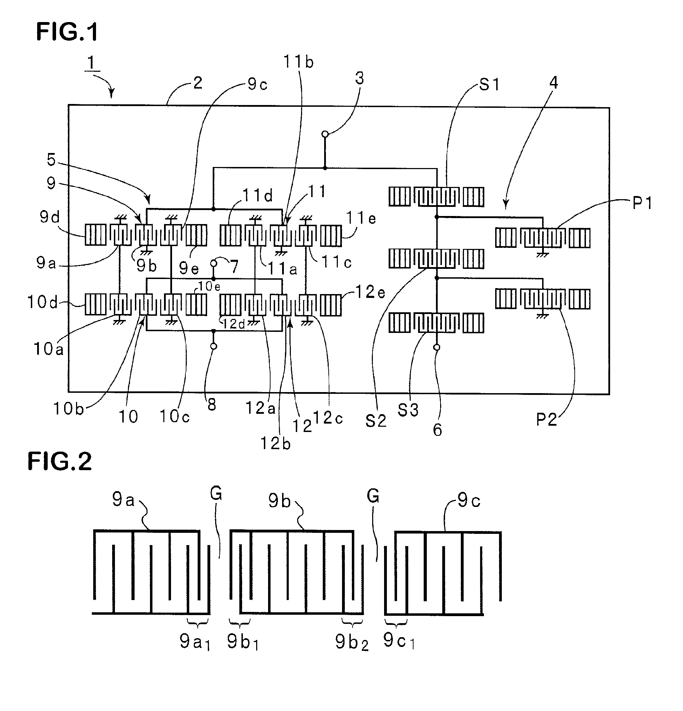

Fig. 1 is a plan view that schematically illustrates a duplexer according to a first embodiment of the invention.

A duplexer 1 is provided with a piezoelectric substrate 2. The piezoelectric substrate 2 according to the present embodiment of the invention is made of 42° Y-cut X-propagation LiTaO₃. The piezoelectric substrate 2 may be made of LiTaO₃ with other cut angle. Or, the piezoelectric substrate 2 may be made of other piezoelectric single crystal such as LiNbO₃ or may be made of piezoelectric ceramics.

An electrode structure illustrated therein is formed over the piezoelectric substrate 2 so as to make up the duplexer 1. In the present embodiment of the invention, Al is used as an electrode material that forms the electrode structure. Notwithstanding the above, Cu or Au may be used as the electrode material. Or, an alloy may be used as the electrode material. As another example, electrodes may be formed as a lamination of a plurality of metal films.

The duplexer 1 according to the present embodiment of the invention is an EGSM duplexer. The EGSM transmission frequency band ranges from 880 MHz to 915 MHz. The EGSM reception frequency band ranges from 925 MHz to 960 MHz.

The duplexer 1 is provided with a common terminal 3, which serves as an unbalanced terminal. A transmission-side band pass filter 4 and a reception-side band pass filter 5 are connected to the common terminal 3. The transmission-side band pass filter 4 is an example of a first band pass filter. The reception-side band pass filter 5 is an example of a second band pass filter.

The transmission-side band pass filter 4 is provided with a transmission terminal 6. A signal that is to be transmitted is inputted to the transmission terminal 6. The signal is sent to the common terminal 3, which is connected to an antenna. The transmission-side band pass filter 4 is a ladder filter that includes a plurality of serial arm resonators S1, S2, and S3 and a plurality of parallel arm resonators P1 and P2. Each of the serial arm resonators S1, S2, and S3 and the parallel arm resonators P1 and P2 described herein is formed with the use of a single port type surface acoustic wave resonator. That is, the transmission-side band pass filter 4 is a ladder type surface acoustic wave filter apparatus.

On the other hand, the reception-side band pass filter 5 is provided with a first balanced terminal 7 and a second balanced terminal 8. Being provided with the common terminal 3 that serves as an unbalanced terminal and further provided with the first balanced terminal 7 and the second balanced terminal 8, the reception-side band pass filter 5 behaves as a BPF that has a balanced/unbalanced conversion function. The impedance of the common terminal 3 is 50Ω. The impedance of the first balanced terminal 7 and the second balanced terminal 8 is 100Ω. In the present embodiment of the invention, a circuit that is made up of a first longitudinally coupled resonator surface acoustic wave filter part 9 and a second longitudinally coupled resonator surface acoustic wave filter part 10 that are connected in cascade and another circuit that is made up of another first longitudinally coupled resonator surface acoustic wave filter part 11 and another second longitudinally coupled resonator surface acoustic wave filter part 12 that are connected in cascade are connected to the common terminal 3.

The first longitudinally coupled resonator surface acoustic wave filter part 9 includes three IDTs, that is, a first IDT 9a, a second IDT 9b, and a third IDT 9c, which are arrayed in a surface acoustic wave propagation direction. The first longitudinally coupled resonator surface acoustic wave filter part 11 also includes three IDTs, that is, a first IDT 11a, a second IDT 11b, and a third IDT 11c, which are arrayed in the surface acoustic wave propagation direction. A reflector 9d is provided next to one side of an area where the first IDT 9a, the second IDT 9b, and the third IDT 9c are provided when viewed in the surface acoustic wave propagation direction. Another reflector 9e is provided next to the other opposite side of the area where the IDTs 9a, 9b, and 9c are provided when viewed in the surface acoustic wave propagation direction. In like manner, the first longitudinally coupled resonator surface acoustic wave filter part 11 is provided with reflectors 11d and 11e.

One end of the second IDT 9b of the first longitudinally coupled resonator surface acoustic wave filter part 9 and one end of the second IDT 11b of the first longitudinally coupled resonator surface acoustic wave filter part 11 are connected in common to the common terminal 3. Each of the other end of the second IDT 9b and the other end of the second IDT 11b is connected to ground potential.

Each of the second longitudinally coupled resonator surface acoustic wave filter parts 10 and 12 is also a 3IDT-type longitudinally coupled resonator surface acoustic wave filter. The second longitudinally coupled resonator surface acoustic wave filter part 10 includes a first IDT 10a, a second IDT 10b, and a third IDT 10c arrayed in sequence along the surface acoustic wave propagation direction. The second longitudinally coupled resonator surface acoustic wave filter part 12 includes a first IDT 12a, a second IDT 12b, and a third IDT 12c arrayed in sequence along the surface acoustic wave propagation direction. As in the configuration of the first longitudinally coupled resonator surface acoustic wave filter part, the second longitudinally coupled resonator surface acoustic wave filter part 10 includes reflectors 10d and 10e that are provided next to the respective sides of an IDT area when viewed in the surface acoustic wave propagation direction. The second longitudinally coupled resonator surface acoustic wave filter part 12 also includes reflectors 12d and 12e that are provided next to the respective sides of an IDT area when viewed in the surface acoustic wave propagation direction.

Each of one end of the first IDT 9a of the first longitudinally coupled resonator surface acoustic wave filter part 9 and one end of the third IDT 9c thereof is connected to ground potential. The other end of the first IDT 9a of the first longitudinally coupled resonator surface acoustic wave filter part 9 is connected to one end of the first IDT 10a of the second longitudinally coupled resonator surface acoustic wave filter part 10. The other end of the first IDT 10a thereof is connected to ground potential. In like manner, with the one end of the third IDT 9c of the first longitudinally coupled resonator surface acoustic wave filter part 9 being connected to ground potential, the other end thereof is connected to one end of the third IDT 10c of the second longitudinally coupled resonator surface acoustic wave filter part 10. The other end of the third IDT 10c thereof is connected to ground potential.

As in the connection between the first longitudinally coupled resonator surface acoustic wave filter part 9 and the second longitudinally coupled resonator surface acoustic wave filter part 10, the first IDT 11a of the first longitudinally coupled resonator surface acoustic wave filter part 11 and the first IDT 12a of the second longitudinally coupled resonator surface acoustic wave filter part 12 are connected to each other; and in addition, the third IDT 11c and the third IDT 12c are connected to each other. Other ends of the IDTs 11a, 11c, 12a, and 12c, not connected to the other IDTs, are connected to ground potential.

One end of the second IDT 10b of the second longitudinally coupled resonator surface acoustic wave filter part 10, which is provided at the center thereof, and one end of the second IDT 12b of the second longitudinally coupled resonator surface acoustic wave filter part 12, which is provided at the center thereof, are connected in common to the first balanced terminal 7. In addition, the other end of the second IDT 10b of the second longitudinally coupled resonator surface acoustic wave filter part 10 and the other end of the second IDT 12b of the second longitudinally coupled resonator surface acoustic wave filter part 12 are connected in common to the second balanced terminal 8.

Having such a connection structure, each of the circuit that is made up of the first longitudinally coupled resonator surface acoustic wave filter part 9 and the second longitudinally coupled resonator surface acoustic wave filter part 10 that are connected in cascade and the circuit that is made up of the first longitudinally coupled resonator surface acoustic wave filter part 11 and the second longitudinally coupled resonator surface acoustic wave filter part 12 that are connected in cascade is a float-balance type surface acoustic wave filter having a balanced/unbalanced conversion function.

Although they are not illustrated in Fig. 1 for simplicity, each of the first longitudinally coupled resonator surface acoustic wave filter part 9, the second longitudinally coupled resonator surface acoustic wave filter part 10, the first longitudinally coupled resonator surface acoustic wave filter part 11, and the second longitudinally coupled resonator surface acoustic wave filter part 12 is provided with narrow pitch electrode finger parts. The term "narrow pitch electrode finger part" is defined as a part that is made up of, at a regional part where two IDTs are provided opposite to each other when viewed in the surface acoustic wave propagation direction with a gap being formed therebetween, at least a part of electrode fingers facing the gap. In addition, the narrow pitch electrode finger part means an electrode finger part whose electrode finger pitch is smaller, that is, narrower, than that of the remaining electrode finger part.

As an example of the structure of such a narrow pitch electrode finger part, an explanation is given of narrow pitch electrode finger parts of the first IDT 9a, the second IDT 9b, and the third IDT 9c of the first longitudinally coupled resonator surface acoustic wave filter part 9 while referring to an enlarged view of Fig. 2. Narrow pitch electrode finger parts 9a₁ and 9b₁ are provided at a regional part where the first IDT 9a and the second IDT 9b are provided opposite to each other with a gap G being formed therebetween. The narrow pitch electrode finger part 9a₁ is made up of a plurality of electrode fingers whose electrode finger pitch is narrower than that of the remaining electrode finger part of the first IDT 9a. In like manner, the second IDT 9b and the third IDT 9c are provided with narrow pitch electrode finger parts 9b₂ and 9c₁, respectively, at a regional part where the second IDT 9b and the third IDT 9c are provided opposite to each other with another gap G being formed therebetween. Accordingly, the second IDT 9b arrayed at the center thereof includes the narrow pitch electrode finger part 9b₁ provided at one side thereof and the narrow pitch electrode finger part 9b₂ provided at the other side thereof when viewed in the surface acoustic wave propagation direction. The electrode finger pitch of each of the narrow pitch electrode finger parts 9b₁ and 9b₂ is narrower than that of the remaining electrode finger part of the second IDT 9b.

Each of the second longitudinally coupled resonator surface acoustic wave filter part 10, the first longitudinally coupled resonator surface acoustic wave filter part 11, and the second longitudinally coupled resonator surface acoustic wave filter part 12 is provided with narrow pitch electrode finger parts having the same structure as above. It is known in the field of a longitudinally coupled resonator surface acoustic wave filter that it is possible to improve the continuity of a surface acoustic wave propagation path between two IDTs by providing narrow pitch electrode finger parts at a gap-facing region where the two IDTs are provided adjacent to each other. In addition, it is further known in the art that the improved path continuity makes it possible to reduce insertion loss in a surface acoustic wave filter having a balanced/unbalanced conversion function. As in such a conventional structure of a longitudinally coupled resonator surface acoustic wave filter, the narrow pitch electrode finger parts are provided in the present embodiment of the invention in order to reduce insertion loss.

In addition, the present embodiment of the invention is characterized in that the number of electrode fingers of the narrow pitch electrode finger part of each of the second IDT 9b of the first longitudinally coupled resonator surface acoustic wave filter part 9 and the second IDT 11b of the first longitudinally coupled resonator surface acoustic wave filter part 11 is larger than the number of electrode fingers of the narrow pitch electrode finger part of each of the second IDT 10b of the second longitudinally coupled resonator surface acoustic wave filter part 10 and the second IDT 12b of the second longitudinally coupled resonator surface acoustic wave filter part 12. With such a characteristic structure, it is possible to increase impedance in the pass band of the transmission-side band pass filter 4 without causing an increase in insertion loss in the reception-side band pass filter 5, which is an example of the second band pass filter that has a relatively high pass band. A detailed explanation is given below on the basis of an example of experiment for exemplification of the above.

The design specification of the first longitudinally coupled resonator surface acoustic wave filter part 9 is as follows:
Let the wavelength thereof be λI, which is determined on the basis of an IDT electrode finger pitch.

Electrode finger cross width in the IDT 9a-9c = 18.6 λI
The number of the electrode fingers of the IDT 9a, 9c = 30
In the above equation, three among the thirty electrode fingers thereof constitute the electrode fingers of the narrow pitch electrode finger part.

The number of the electrode fingers of the IDT 9b = 38
In the above equation, the number of the electrode fingers of each of the narrow pitch electrode finger parts provided at both sides thereof is equal to seven. Therefore, the number of the electrode fingers of the IDT 9b excluding both of the narrow pitch electrode finger parts thereof is equal to 24 (38 - 7 - 7 = 24).

The number of the electrode fingers of the reflector 9d, 9e = 65

Metallization ratio = 0.73
Electrode film thickness = 0.095 λI
The design specification of the first longitudinally coupled resonator surface acoustic wave filter part 11 is the same as that of the first longitudinally coupled resonator surface acoustic wave filter part 9.

The design specification of the second longitudinally coupled resonator surface acoustic wave filter part 10 is as follows:
Let the wavelength thereof be λI, which is determined on the basis of an IDT electrode finger pitch.

Electrode finger cross width in the IDT 10a-10c = 18.6 λI
The number of the electrode fingers of the IDT 10a, 10c = 30
In the above equation, three among the thirty electrode fingers thereof constitute the electrode fingers of the narrow pitch electrode finger part.

The number of the electrode fingers of the IDT 10b = 38
In the above equation, the number of the electrode fingers of each of the narrow pitch electrode finger parts provided at both sides thereof is equal to four. Therefore, the number of the electrode fingers of the IDT 10b excluding both of the narrow pitch electrode finger parts thereof is equal to 30 (38 - 4 - 4 = 30).

The number of the electrode fingers of each reflector = 65

Metallization ratio = 0.73
Electrode film thickness = 0.095 λI
The design specification of the second longitudinally coupled resonator surface acoustic wave filter part 12 is the same as that of the second longitudinally coupled resonator surface acoustic wave filter part 10.

As explained above, the number of the electrode fingers of each of the narrow pitch electrode finger parts provided at both sides of each of the second IDTs 9b and 11b of the first longitudinally coupled resonator surface acoustic wave filter parts that are connected to the common terminal 3 is seven, which is larger than the number of the electrode fingers of each of the narrow pitch electrode finger parts provided at both sides of each of the second IDTs 10b and 12b of the second longitudinally coupled resonator surface acoustic wave filter parts, that is, four.

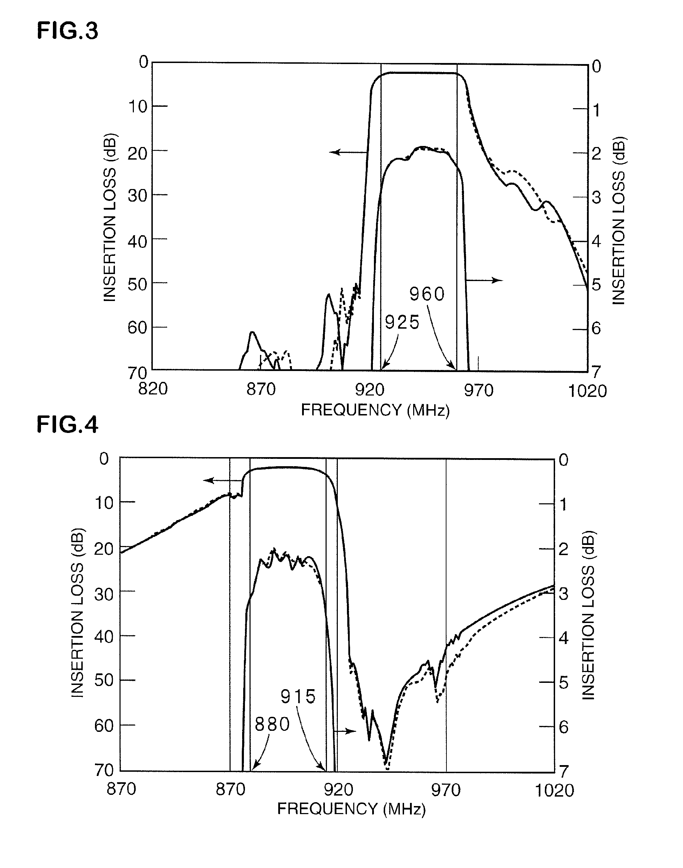

Fig. 3 illustrates the transmission characteristics of the reception-side band pass filter 5 in the duplexer 1 according to the present embodiment of the invention. Note that enlarged transmission characteristics are shown together with the transmission characteristics of the reception-side band pass filter 5 in Fig. 3. On the other hand, Fig. 4 illustrates the transmission characteristics of the transmission-side band pass filter 4. Note that enlarged transmission characteristics are shown together with the transmission characteristics of the transmission-side band pass filter 4 in Fig. 4.

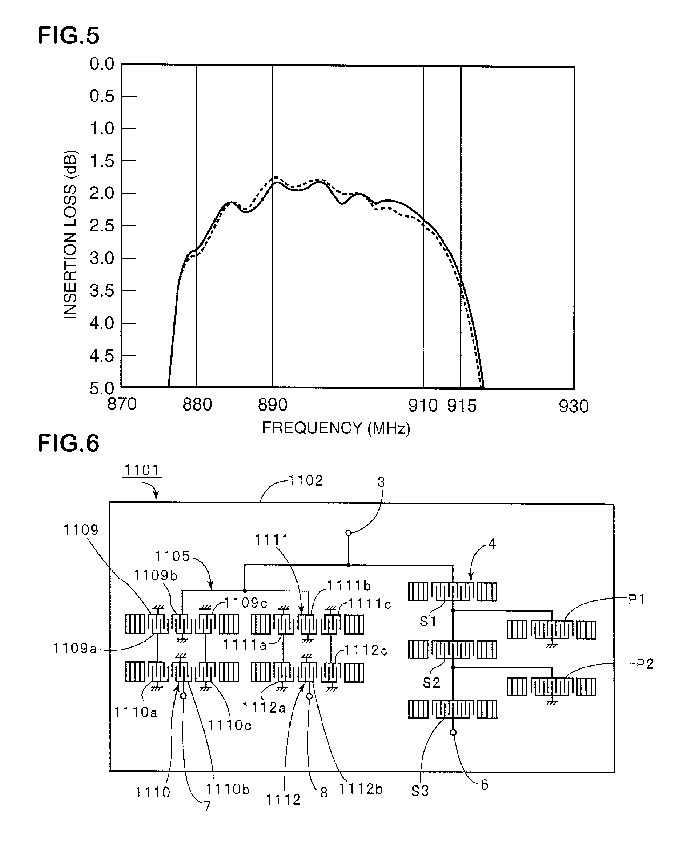

A duplexer 1101 according to a comparative example that has an electrode structure illustrated in Fig. 6 was prepared for the purpose of comparison. The transmission characteristics of the duplexer 1101 according to the comparative example were measured. The configuration of the duplexer 1101 according to the comparative example is as follows. The configuration of a piezoelectric substrate 1102 of the duplexer 1101 according to the comparative example and the material of electrodes formed on the piezoelectric substrate 1102 are the same as those of the duplexer 1 according to the present embodiment of the invention. In addition, the transmission-side band pass filter 4 of the duplexer 1101 according to the comparative example is the same as the transmission-side band pass filter 4 of the duplexer 1 according to the present embodiment of the invention. The difference between the duplexer 1101 according to the comparative example and the duplexer 1 according to the present embodiment of the invention lies in that, in the configuration of a reception-side band pass filter 1105 of the former, a circuit that is made up of a first longitudinally coupled resonator surface acoustic wave filter part 1109 and a second longitudinally coupled resonator surface acoustic wave filter part 1110 that are connected in cascade and a circuit that is made up of a first longitudinally coupled resonator surface acoustic wave filter part 1111 and a second longitudinally coupled resonator surface acoustic wave filter part 1112 that are connected in cascade are connected in parallel.

Each of the first longitudinally coupled resonator surface acoustic wave filter parts 1109 and 1111 described here is a 3IDT-type longitudinally coupled resonator surface acoustic wave filter. One end of the center IDT 1109b of the first longitudinally coupled resonator surface acoustic wave filter part 1109 and one end of the center IDT 1111b of the first longitudinally coupled resonator surface acoustic wave filter part 1111 are connected in common to the common terminal 3, which serves as an unbalanced terminal. The first longitudinally coupled resonator surface acoustic wave filter part 1109 and the second longitudinally coupled resonator surface acoustic wave filter part 1110 are connected to each other in the same manner as in the connection according to the example embodiment of the invention explained above. In addition, the first longitudinally coupled resonator surface acoustic wave filter part 1111 and the second longitudinally coupled resonator surface acoustic wave filter part 1112 are connected to each other in the same manner as in the connection according to the example embodiment of the invention explained above.

However, in this comparative example, one end of the second IDT 1110b of the second longitudinally coupled resonator surface acoustic wave filter part 1110, which is provided at the center thereof, is connected to ground potential whereas the other end thereof is connected to the first balanced terminal 7. In addition, one end of the center second IDT 1112b of the other of the two second longitudinally coupled resonator surface acoustic wave filter parts, that is, the second longitudinally coupled resonator surface acoustic wave filter part 1112, is connected to ground potential whereas the other end thereof is connected to the second balanced terminal 8. In order to ensure that the longitudinally coupled resonator surface acoustic wave filter has a balanced/unbalanced conversion function, the IDTs 1110b and 1112b are formed in such a manner that the phase of the transmission characteristics of the second IDT 1112b is reversed with respect to the transmission characteristics of the second IDT 1110b.

Therefore, the reception-side band pass filter 1105 of the duplexer 1101 according to the comparative example is a neutral-point type longitudinally coupled resonator surface acoustic wave filter having a balanced/unbalanced conversion function.

The duplexer 1101 according to the comparative example is designed with the following specification.

The design specification of the first longitudinally coupled resonator surface acoustic wave filter part 1109:
Let the wavelength thereof be λI, which is determined on the basis of an IDT electrode finger pitch.

Electrode finger cross width in the IDT 1109a-1109c = 33.9 λI
The number of the electrode fingers of the IDT 1109a, 1109c = 32
In the above equation, three among the thirty-two electrode fingers thereof constitute the electrode fingers of the narrow pitch electrode finger part.

The number of the electrode fingers of the IDT 1109b = 28
A narrow pitch electrode finger part that has three electrode fingers is provided at each of the two sides of the IDT 1109b. Therefore, the number of the electrode fingers of the IDT 1109b excluding both of the narrow pitch electrode finger parts thereof is equal to 22 (28 - 3 - 3 = 22).

The number of the electrode fingers of each reflector = 65

Metallization ratio = 0.73
Electrode film thickness = 0.095 λI
The design specification of the first longitudinally coupled resonator surface acoustic wave filter part 1111 is the same as that of the first longitudinally coupled resonator surface acoustic wave filter part 1109.

The design specification of the second longitudinally coupled resonator surface acoustic wave filter part 1110:
Let the wavelength thereof be λI, which is determined on the basis of an IDT electrode finger pitch.

Electrode finger cross width in the IDT 1110a-1110c = 33.9 λI
The number of the electrode fingers of the IDT 1110a, 1110c = 32
In the above equation, three among the thirty-two electrode fingers thereof constitute the electrode fingers of the narrow pitch electrode finger part.

The number of the electrode fingers of the IDT 1110b = 44
In the above equation, the number of the electrode fingers of each of the narrow pitch electrode finger parts provided at both sides thereof is equal to seven. Therefore, the number of the electrode fingers of the IDT 1110b excluding both of the narrow pitch electrode finger parts thereof is equal to 30 (44 - 7 - 7 = 30).

The number of the electrode fingers of each reflector = 65

Metallization ratio = 0.73
Electrode film thickness = 0.095 λI
The design specification of the second longitudinally coupled resonator surface acoustic wave filter part 1112 is the same as that of the second longitudinally coupled resonator surface acoustic wave filter part 1110 except that, as explained earlier, the orientation of the IDT 1112b is not the same as the orientation of the IDT 1110b.

As explained above, the reception-side band pass filter 1105 of the duplexer 1101, which is prepared as the comparative example, is a neutral-point type longitudinally coupled resonator surface acoustic wave filter having a balanced/unbalanced conversion function. In addition, the number of the electrode fingers of each of the narrow pitch electrode finger parts provided at both sides of each of the second IDTs 1109b and 1111b of the first longitudinally coupled resonator surface acoustic wave filter parts that are connected to the common terminal 3 is smaller than the number of the electrode fingers of each of the narrow pitch electrode finger parts provided at both sides of each of the second IDT 1110b of the second longitudinally coupled resonator surface acoustic wave filter part 1110, which is connected to the first balanced terminal 7, and the second IDT 1112b of the second longitudinally coupled resonator surface acoustic wave filter part 1112, which is connected to the second balanced terminal 8.

In Figs. 3 and 4, the transmission characteristics of the reception-side band pass filter of the duplexer 1101, which is prepared as the comparative example, and the transmission characteristics of the transmission-side band pass filter thereof are shown respectively, each by a broken line.

As understood from Fig. 3, in the reception-side band pass filter, insertion loss in the pass band and attenuation in the transmission-side band of the example embodiment of the invention explained above and those of the comparative example are almost equal to each other. In contrast, as understood from Fig. 4, the transmission characteristics of the transmission-side band pass filter according to the foregoing embodiment of the invention has greater steepness at the high pass-band side in comparison with those of the comparative example, which results in a reduction in insertion loss.

For further clarification, characteristics obtained when loss due to impedance mismatching in the transmission-side band pass filter is eliminated through calculation are shown in Fig. 5. The solid line of Fig. 5 indicates the result according to the present embodiment of the invention. The broken line of Fig. 5 indicates the result according to the comparative example.

The EGSM transmission frequency band ranges from 880 MHz to 915 MHz. As understood from Fig. 5, insertion loss is the largest at 915 MHz in this transmission frequency band. As indicated by the solid line of Fig. 5, it is understood that the present embodiment of the invention makes it possible to improve the insertion loss in the pass band, which is better than that of the comparative example by approximately 0.2 dB.

As explained above, according to the present embodiment of the invention, in the reception-side band pass filter, it is possible to increase impedance in the pass band of the transmission-side band pass filter so as to achieve sufficiently large attenuation in the transmission-side band pass filter; and in addition thereto, it is possible to improve the insertion loss of the transmission-side band pass filter. It is conceivable that these advantages are attributable to the following reasons.

In the present embodiment of the invention, as explained above, the reception-side band pass filter 5 is a float type surface acoustic wave filter having a balanced/unbalanced conversion function. In addition, the present embodiment of the invention is further **characterized in that** the number of electrode fingers of the narrow pitch electrode finger part of each of the IDTs 9b and 11b connected to the common terminal 3, which serves as an unbalanced terminal, is larger than the number of electrode fingers of the narrow pitch electrode finger part of each of the IDTs 10b and 12b connected to the first balanced terminal 7 and the second balanced terminal 8. Generally speaking, impedance decreases as the number of electrode fingers of a narrow pitch electrode finger part increases. Impedance increases as the number of electrode fingers of a narrow pitch electrode finger part decreases. In addition, in a float type filter, if an unbalanced-terminal-side filter has almost the same design as that of a balanced-terminal-side filter, the ratio of the impedance of a balanced terminal to the impedance of an unbalanced terminal is approximately 1: 1. Therefore, in order to ensure that the ratio of the impedance of a balanced terminal to the impedance of an unbalanced terminal is larger than 1: 1, or more specifically, in order to ensure that the ratio of the impedance of a balanced terminal to the impedance of an unbalanced terminal approximates 2: 1 as described in the foregoing embodiment of the invention, it is possible to achieve impedance matching by making the number of electrode fingers of the narrow pitch electrode finger part of each of the IDTs 9b and 11b connected to the unbalanced terminal relatively large and by making the number of electrode fingers of the narrow pitch electrode finger part of each of the IDTs 10b and 12b connected to the first balanced terminal 7 and the second balanced terminal 8 relatively small.

In contrast, in a neutral-point type filter, if an unbalanced-terminal-side filter has almost the same design as that of a balanced-terminal-side filter, the ratio of the impedance of a balanced terminal to the impedance of an unbalanced terminal is approximately 4: 1. Therefore, in order to ensure that the ratio of the impedance of a balanced terminal to the impedance of an unbalanced terminal approximates 2: 1 as described in the comparative example, it is possible to achieve impedance matching by making the number of electrode fingers of the narrow pitch electrode finger part of each of the IDTs 1109b and 1111b connected to the unbalanced terminal relatively small and by making the number of electrode fingers of the narrow pitch electrode finger part of each of the IDT 1110b connected to the first balanced terminal 7 and the IDT 1112b connected to the second balanced terminal 8 relatively large.

Therefore, in order to obtain such characteristics that the ratio of the impedance of a balanced terminal to the impedance of an unbalanced terminal is not smaller than 1: 1 but not larger than 4: 1, the number of electrode fingers of each of IDTs connected to the common terminal 3, which serves as an unbalanced terminal, inclusive of the number of electrode fingers of the narrow pitch electrode finger parts thereof in the configuration of the float type filter is larger than that of the neutral-point type filter. Therefore, the float type filter has a smaller influence on the transmission-side band pass filter in comparison with that of the neutral-point type filter. Thus, the foregoing embodiment of the invention offers improved insertion loss in the transmission-side band pass filter, which is better than that of the comparative example explained above.

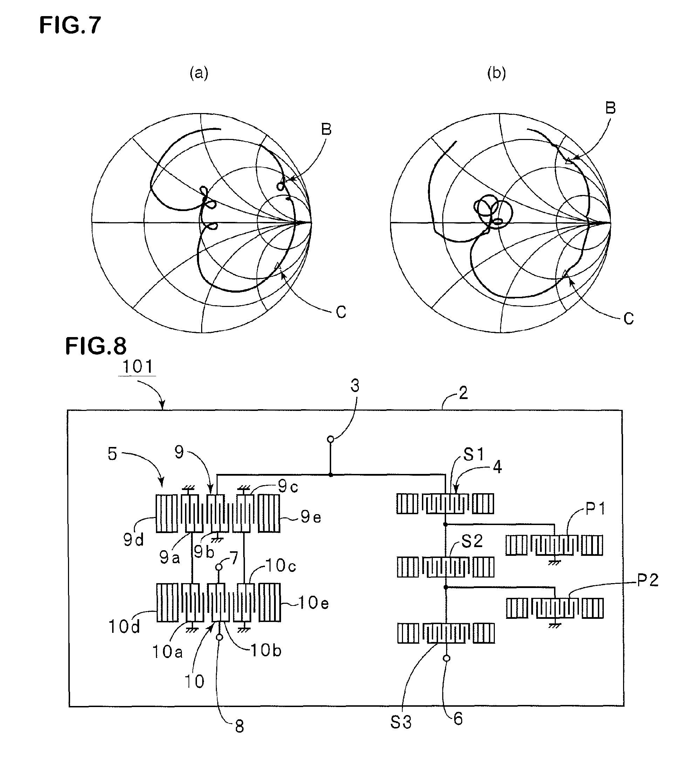

Figs. 7(a) and 7(b) are impedance Smith charts that illustrate impedance in the common terminal 3 obtained when the transmission-side band pass filter is removed in the foregoing embodiment of the invention and the comparative example, respectively. In Fig. 7(a), 7(b), a marker B indicates impedance at 880 MHz, whereas a marker C indicates impedance at 915 MHz. That is, the markers B and C indicate the impedance of the reception-side band pass filter at the lowest frequency of the pass band of the transmission-side band pass filter and at the highest frequency thereof, respectively.

When impedance of the reception-side band pass filter as a single unit is considered, it is possible to make an influence on the transmission-side band pass filter smaller as the impedance of the reception-side band pass filter in the pass band of the transmission-side band pass filter goes to a relatively outer side of a Smith chart where a resistance component is relatively large. As understood from Figs. 7(a) and 7(b), in the reception-side band pass filter according to the foregoing embodiment of the invention, which is the float type shown in Fig. 7(a), since impedance in the transmission-side pass band is shifted to a relatively outer side of the Smith chart so that a resistance component of impedance in the pass band of the transmission-side band pass filter is relatively large, an influence on the transmission-side band pass filter is smaller in comparison with that of the neutral-point type filter.

In the foregoing embodiment of the invention, the transmission-side band pass filter 4 is a surface acoustic wave filter having a ladder-type circuit configuration, whereas the reception-side band pass filter 5 has such a configuration that a circuit that is made up of the first longitudinally coupled resonator surface acoustic wave filter part 9 and the second longitudinally coupled resonator surface acoustic wave filter part 10 that are connected in cascade and a circuit that is made up of the first longitudinally coupled resonator surface acoustic wave filter part 11 and the second longitudinally coupled resonator surface acoustic wave filter part 12 that are connected in cascade are connected in parallel. Notwithstanding the above, in a duplexer according to the present invention, the circuit configuration of the first band pass filter that is embodied as the transmission-side band pass filter explained above and/or the circuit configuration of the second band pass filter that is embodied as the reception-side band pass filter explained above may be arbitrarily modified.

That is, the transmission-side band pass filter 4 is not limited to a surface acoustic wave filter having a ladder-type circuit configuration. The transmission-side band pass filter 4 may be a longitudinally coupled resonator surface acoustic wave filter. That is, the circuit configuration of the transmission-side band pass filter 4, which is an example of the first band pass filter, is not limited to the illustrated example.

In the foregoing embodiment of the invention, the reception-side band pass filter 5 has such a configuration that a circuit that is made up of the first longitudinally coupled resonator surface acoustic wave filter part 9 and the second longitudinally coupled resonator surface acoustic wave filter part 10 that are connected in cascade and a circuit that is made up of the first longitudinally coupled resonator surface acoustic wave filter part 11 and the second longitudinally coupled resonator surface acoustic wave filter part 12 that are connected in cascade are connected in parallel. Notwithstanding the above, as illustrated in Fig. 8, a duplexer 101 may include a single circuit that is made up of the first longitudinally coupled resonator surface acoustic wave filter part 9 and the second longitudinally coupled resonator surface acoustic wave filter part 10 that are connected in cascade only.

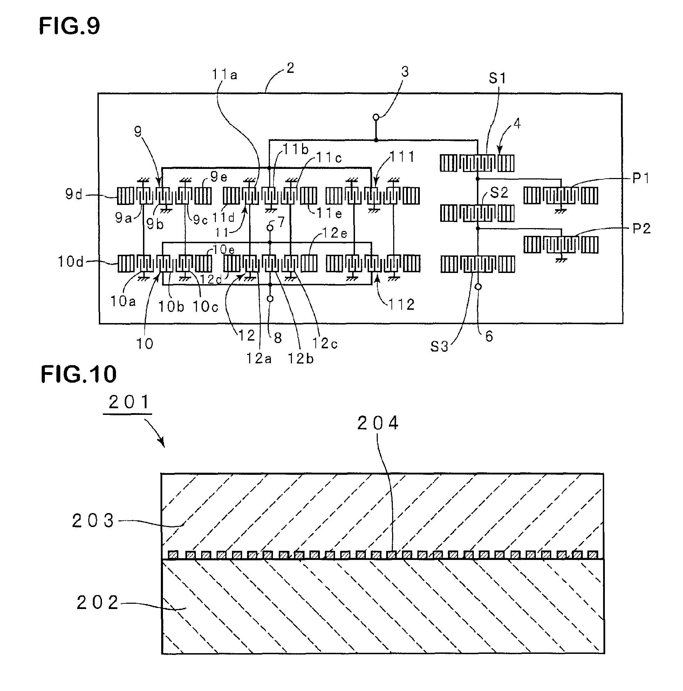

Or, as another modification example shown in Fig. 9, a circuit that is made up of another pair of a first longitudinally coupled resonator surface acoustic wave filter part 111 and a second longitudinally coupled resonator surface acoustic wave filter part 112 that are connected in cascade, the circuit that is made up of the first longitudinally coupled resonator surface acoustic wave filter part 9 and the second longitudinally coupled resonator surface acoustic wave filter part 10 that are connected in cascade, and the circuit that is made up of the first longitudinally coupled resonator surface acoustic wave filter part 11 and the second longitudinally coupled resonator surface acoustic wave filter part 12 that are connected in cascade may be connected in parallel. As explained above, the number of circuits each of which is made up of a first longitudinally coupled resonator surface acoustic wave filter part and a second longitudinally coupled resonator surface acoustic wave filter part that are connected in cascade may be any arbitrary number of two or greater, where respective one ends of these circuits are connected in common to the common terminal 3. That is, the number of circuit(s) that are connected in parallel are not restrictively specified herein.

Although the second band pass filter according to the present invention is provided in the duplexer 1 in the example embodiment described above, the scope of the invention is not limited thereto. That is, the invention is applicable to a second band pass filter for various kinds of uses that is provided in various kinds of a device that includes a first band pass filter and the second band pass filter that have pass bands that are different from each other, where one end of the first band pass filter and one end of the second band pass filter are connected in common, and where the second band pass filter has a balanced/unbalanced conversion function.

Although a surface acoustic wave filter apparatus is taken as an example in the foregoing embodiment of the invention and the modification example thereof, the invention is also applicable to a boundary acoustic wave filter apparatus that utilizes a boundary acoustic wave in place of a surface acoustic wave. Specifically, in the structure of a boundary acoustic wave filter apparatus 201 that is schematically illustrated in a front-elevation sectional view of Fig. 10, a dielectric 203 is formed as a layer on a piezoelectric substrate 202, which is made of a piezoelectric material. An electrode structure 204 inclusive of IDTs is provided on a boundary face between the piezoelectric substrate 202 and the dielectric 203. The electrode structure according to an example embodiment of the invention explained earlier is formed as the electrode structure 204. In this way, it is possible to provide a boundary acoustic wave filter apparatus according to the present invention.

## Claims

1. An acoustic wave filter apparatus that has a balanced/unbalanced conversion function and is used as a second band pass filter of an acoustic wave filter device that includes a first band pass filter that has a pass band at a relatively low frequency side and the second band pass filter that has a pass band at a relatively high frequency side, one end of the first band pass filter and one end of the second band pass filter being connected to a common terminal, the acoustic wave filter apparatus comprising:
a piezoelectric substrate; and
a first longitudinally coupled resonator acoustic wave filter part and a second longitudinally coupled resonator acoustic wave filter part that are formed over the piezoelectric substrate,
wherein each of the first longitudinally coupled resonator acoustic wave filter part and the second longitudinally coupled resonator acoustic wave filter part includes a first IDT, a second IDT, and a third IDT arrayed in sequence along a propagation direction of an acoustic wave,
one end of the first IDT of the first longitudinally coupled resonator acoustic wave filter part and one end of the first IDT of the second longitudinally coupled resonator acoustic wave filter part are connected to each other, and in addition thereto, one end of the third IDT of the first longitudinally coupled resonator acoustic wave filter part and one end of the third IDT of the second longitudinally coupled resonator acoustic wave filter part are connected to each other so that the first longitudinally coupled resonator acoustic wave filter part and the second longitudinally coupled resonator acoustic wave filter part are connected in cascade,
an end of the second IDT of the first longitudinally coupled resonator acoustic wave filter part is connected to the common terminal,
one end of the second IDT of the second longitudinally coupled resonator acoustic wave filter part is connected to a first balanced terminal whereas the other end of the second IDT of the second longitudinally coupled resonator acoustic wave filter part is connected to a second balanced terminal,
each of the first longitudinally coupled resonator acoustic wave filter part and the second longitudinally coupled resonator acoustic wave filter part has a narrow pitch electrode finger part that is provided at a gap-facing part in a pair of the IDTs that are provided adjacent to each other with a gap being formed therebetween when viewed in the acoustic wave propagation direction,
a cycle of electrode fingers of the narrow pitch electrode finger part is smaller than a cycle of electrode fingers of an IDT part excluding the narrow pitch electrode finger part, and
the number of the electrode fingers of the narrow pitch electrode finger part of the second IDT of the first longitudinally coupled resonator acoustic wave filter part is larger than the number of the electrode fingers of the narrow pitch electrode finger part of the second IDT of the second longitudinally coupled resonator acoustic wave filter part.

2. An acoustic wave filter apparatus that includes a plurality of acoustic wave filter apparatuses according to Claim 1, wherein the plurality of acoustic wave filter apparatuses are connected in parallel.

3. An acoustic wave filter apparatus according to Claim 1 or Claim 2, wherein a surface acoustic wave is used as the acoustic wave so that the acoustic wave filter apparatus is configured as a surface acoustic wave filter apparatus.

4. An acoustic wave filter apparatus according to Claim 1 or Claim 2, wherein a boundary acoustic wave is used as the acoustic wave so that the acoustic wave filter apparatus is configured as a boundary acoustic wave filter apparatus.

5. A duplexer comprising:
a first band pass filter that has a relatively low pass band; and
a second band pass filter that has a relatively high pass band,
wherein one end of the first band pass filter and one end of the second band pass filter are connected to a common terminal; and
the second band pass filter is an acoustic wave filter apparatus according to any of Claims 1 to 4.
